# EUROPEAN PATENT SPECIFICATION

(11) **EP 2 610 902 B1**
(45) Date of publication and mention of the grant of the patent: **01.01.2020**
(21) Application number: 11819740.9
(22) Date of filing: 28.07.2011
(51) Int. Cl.: H01L 21/67

(54) **SHEET ADHERING DEVICE AND ADHERING METHOD**
FOLIENHAFTVORRICHTUNG UND HAFTVERFAHREN
DISPOSITIF DE COLLAGE DE FEUILLE ET PROCÉDÉ DE COLLAGE

(30) Priority: 26.08.2010 JP 2010189689
(43) Date of publication of application: 03.07.2013
(73) Proprietor: LINTEC Corporation, Tokyo 173-0001 (JP)
(72) Inventor: TAKANO Takeshi, Tokyo 173-0001 (JP)
(74) Representative: Hoffmann Eitle
(86) International application number: PCT/JP2011/067212
(87) International publication number: WO 2012/026275

(56) References cited:
- JP-A- 2007 134 527
- JP-A- 2007 311 570
- JP-A- 2007 311 570
- JP-A- 2008 294 026
- JP-A- 2010 103 304
- JP-A- 2010 118 584

## Description

### TECHNICAL FIELD

The present invention relates to a sheet adhering device and a sheet adhering method for attaching an adhesive sheet to an adherend.

### BACKGROUND ART

A sheet adhering device for integrating a semiconductor wafer (adherend: sometimes simply referred to as a "wafer" hereinafter) and a ring frame (frame) with the use of an adhesive sheet has conventionally been employed in a semiconductor manufacturing process (see, for instance, JP-A-2004-87660). Since the adhesive sheet has been attached to the ring frame in advance in the above sheet adhering device, the wafer and the ring frame can be easily integrated only by pressing to the wafer an adhesive layer of the adhesive sheet exposed at an opening of the ring frame.

However, if the adhesive sheet attached to the ring frame is pulled toward the wafer when the adhesive sheet is pressed to the wafer, or if the wafer is pressed to the adhesive sheet at the opening of the ring frame, a tension is applied on the adhesive sheet, which causes a plastic deformation of the adhesive sheet between the adherend and the frame, thereby stretching (i.e. slacking) the adhesive sheet. Thus, since the adherend is integrated in a manner capable of displacement relative to the frame, the adherend cannot be reliably held and consequently may be damaged.

An object of the present disclosure is to provide a sheet adhering device and a sheet adhering method that is adapted to integrate an adhesive sheet with a frame without creating a slack between the adherend and the frame.

JP 2010 118584 A describes a mounting device for a wafer by which a dicing tape is stuck onto the rugged surface of the wafer. JP 2010 118584 A also describes a dicing tape which is adhered to a dicing frame.

JP 2007 311570 A describes a replacing device and replacing method with a hot air blowing device for removing undulation in a support member, but does not disclose cooling the support member before or after use of the air blowing device.

### SUMMARY OF THE INVENTION

In a first aspect of the present invention, there is provided a sheet adhering device arranged to attach an adhesive sheet to an adherend, the adhesive sheet being attached to an opening of a frame in advance and sized to protrude beyond an outer periphery of the adherend, the sheet adhering device comprising: a pressing unit arranged to press the adhesive sheet to the adherend to attach the adhesive sheet to the adherend; and a slack removal unit that is, or comprises, a heater or cooler arranged to heat or cool the adhesive sheet to remove a slack of a part of the adhesive sheet protruded beyond the outer periphery of the adherend after being attached by the pressing unit, wherein the sheet attaching device is configured to cool the adhesive sheet naturally or forcibly, after heating by the slack removal unit, or wherein the sheet attaching device is configured to heat the adhesive sheet naturally, after cooling by the slack removal unit.

In a second aspect of the present invention, there is provided a sheet adhering method for attaching an adhesive sheet to an adherend, the method comprising: attaching the adhesive sheet in advance to an opening of a frame, the adhesive sheet being sized to protrude beyond an outer periphery of the adherend; pressing the adhesive sheet attached to the opening of the frame to attach the adhesive sheet to the adherend; and heating or cooling the adhesive sheet to remove a slack of the protruding part of the adhesive sheet after the adhesive sheet is attached to the adherend, wherein the adhesive sheet is naturally or forcibly cooled after heating, or wherein the adhesive sheet is naturally heated after cooling.

With embodiments of the above aspects of the invention, since the slack removal unit is provided, the adhesive sheet can be integrated with the frame without creating a slack between the adherend and the frame. Thus, the adherend can be reliably held by the frame and a damage of the adherend can be prevented beforehand.

With embodiments of the above aspects of the invention, by heating or cooling the adhesive sheet after the adhesive sheet is attached to the adherend, the slack of the adhesive sheet between the adherend and the frame can be eliminated when the adhesive sheet is cooled/heated to an ambient temperature after being heated/cooled, so that the slack of the adhesive sheet between the adherend and the frame can be removed with a simple arrangement.

### BRIEF DESCRIPTION OF DRAWINGS

For a better understanding of the invention and to show how the same may be carried into effect, reference will now be made, by way of example, to the accompanying drawings, in which:
Fig. 1 is a partial sectional side elevation showing a sheet adhering device according to an exemplary embodiment of the invention;
Fig. 2A is an illustration showing an operation of the sheet adhering device;
Fig. 2B is another illustration showing the operation of the sheet adhering device;
Fig. 2C is still another illustration showing the operation of the sheet adhering device;
Fig. 3 is an illustration showing another operation of the sheet adhering device;
Fig. 4A shows a condition of the adhesive sheet after being attached;
Fig. 4B shows the condition of the adhesive sheet after being attached;
Fig. 5A shows the condition of the adhesive sheet after being attached;
Fig. 5B shows the condition of the adhesive sheet after being attached;
Fig. 6A shows the condition of the adhesive sheet after being attached; and
Fig. 6B shows the condition of the adhesive sheet after being attached.

### DETAILED DESCRIPTION

Exemplary embodiment(s) of the invention will be described below with reference to the attached drawings.

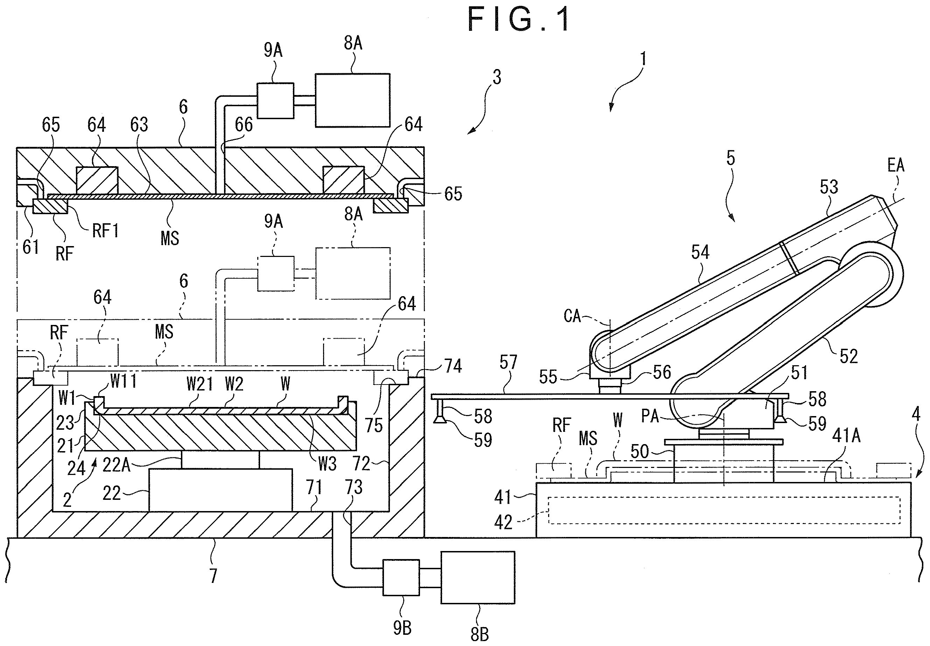

As shown in Fig. 1, a sheet adhering device 1 according to this exemplary embodiment is for attaching a mounting sheet MS (adhesive sheet) that is attached in advance to close an opening RF 1 of a ring frame RF to a wafer W (adherend) to integrate the wafer W and the ring frame RF with the mounting sheet MS. The wafer W is a semiconductor wafer that is ground to provide an outer periphery thicker than the rest of the wafer, whereby an annular convex portion W1 protruded in the thickness direction (toward a back side) is defined on an outer periphery, a cavity W2 is defined at an inside surrounded by the convex portion W1 and a circuitry is formed on a circuit face W3 on a top side (i.e. a side opposite to the ground face and at a lower side in Fig. 1) of the wafer W. A protection sheet (not shown) is attached on the circuit face W3. Further, the mounting sheet MS has a layered structure in which an adhesive layer is laminated on one side of a base material sheet (not shown).

As shown in Fig. 1, the sheet adhering device 1 includes: an adherend support unit 2 that supports the wafer W; a decompression unit 3 that holds the mounting sheet MS at a position opposing the wafer W and keeps the wafer W and the mounting sheet MS in a decompressed atmosphere; a slack removal unit 4 that is provided outside the decompression unit 3 and heats the mounting sheet MS to remove a slack at a part of the mounting sheet MS protruding beyond an outer periphery of the wafer W; and a multijoint robot 5 (drive unit) that transfers the wafer W attached with the mounting sheet MS to the slack removal unit 4.

The adherend support unit 2 includes a disc-shaped table 21 having a profile larger than an outer periphery of the wafer W, and a linear movement motor 22 (drive unit) having an output shaft 22A fixed on a lower face of the table 21. An annular convex portion 23 of which an outer periphery protrudes in thickness direction (upward in Fig. 1) is provided on an upper face 24 of the table 21.

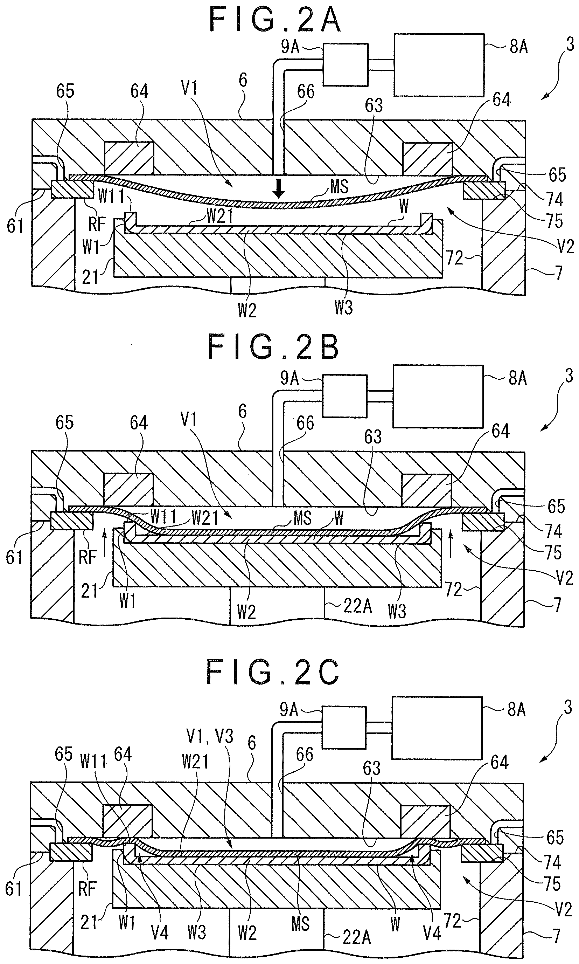

The decompression unit 3 includes a cover member 6 and a lower chamber 7 that support the mounting sheet MS attached on the ring frame RF in a manner opposed with the wafer W, a pressure adjuster 8A (a pressing unit) that is adapted to decompress an inside of a first space V1 defined by the cover member 6 and the mounting sheet MS (see Fig. 2A) and a pressure adjuster 8B (a pressing unit) that is adapted to decompress an inside of a second space V2 (see Fig. 2A) defined by the mounting sheet MS and the lower chamber 7. It should be noted that the cover member 6 and the lower chamber 7 provide a sheet support that supports the mounting sheet MS attached to the ring frame RF.

The cover member 6 is capable of vertical movement by a drive unit (not shown). On a lower face 61 of the cover member 6, a frame holder 63 having concave cross section with the same profile as an outer profile of the ring frame RF, and an elastic member 64 that is embedded in the frame holder 63 with a surface thereof being exposed on the frame holder 63 are provided. A part of the frame holder 63 under which the ring frame RF is located is provided with a plurality of suction holes 65 and is provided by an elastic member to keep the sealability of the first space V1 by conforming with the height gap created by the mounting sheet MS. A pressure adjustment channel 66 connected to the pressure adjuster 8A is provided to the frame holder 63. A pressure detector 9A for detecting a pressure in the first space V1 is provided in the pressure adjustment channel 66.

The lower chamber 7 is provided in a box shape having an opening at an upper face 74 thereof. Specifically, the lower chamber 7 includes a bottom face 71 at which the adherend support unit 2 is provided and a lateral face 72 extending upward from an outer periphery of the bottom face 71. A pressure adjustment channel 73 connected to the pressure adjuster 8B is provided to the bottom face 71. A pressure detector 9B for detecting a pressure in the second space V2 is provided in the pressure adjustment channel 73. A recessed annular support 75 is provided at an inner side of the upper face 74 of the lateral face 72. The ring frame RF attached with the mounting sheet MS is adapted to be supported by the support 75.

In the decompression unit 3, the mounting sheet MS defines separate first space V1 and second space V2. The pressure adjusters 8A and 8B adjust the pressure in the first and second spaces V1 and V2 to press and attach the mounting sheet MS to the wafer W with the use of the differential pressure between the first space V1 and second space V2.

The slack removal unit 4 includes a table 41 on which the wafer W integrated with the ring frame RF via the mounting sheet MS is placed and a heater 42 that is provided in the table 41 and is adapted to heat the mounting sheet MS.

The multijoint robot 5 includes: a base 50; a first arm 51 that is held on the base in a manner rotatable around a vertical axis PA (an axis in up-down direction) relative to the base 50; a second arm 52 that is pivotally supported on the first arm 51 in a manner rotatable around a horizontal axis orthogonal to the vertical axis PA (an axis orthogonal to a plane of Fig. 1); a third arm 53 pivotally supported on the second arm 52 in a manner rotatable around the horizontal axis; a fourth arm 54 pivotally supported on the third arm 53 in a manner rotatable around an extension axis EA of the third arm 53; a fifth arm 55 that is pivotally supported on the fourth arm 54 in a manner rotatable around an axis orthogonal to the extension axis EA (an axis orthogonal to the plane of Fig. 1); a sixth arm 56 that is pivotally supported on the fifth arm 55 in a manner rotatable around an extension axis CA of the fifth arm 55; a frame 57 provided to the sixth arm 56; and suction pads 59 provided via four holder arms 59 (partly not shown) vertically provided on the frame 57 and at an angular interval of 90 degrees. The multijoint robot 5 is adapted to hold the wafer W and the ring frame RF integrated via the mounting sheet MS with the suction pads 59.

A process for attaching the mounting sheet MS on the wafer W in the above-described sheet adhering device 1 will be described below.

Initially, the ring frame RF in which the opening RF1 is closed by the mounting sheet MS is sucked and held on the cover member 6 and the wafer W is mounted on the table 21, with the use of a transfer unit (not shown) as shown in Fig. 1. Subsequently, the decompression unit 3 lowers the cover member 6 by a drive unit (not shown) to bring the lower face 61 of the cover member 6 into contact with the upper face 74 of the lower chamber 7. After the first and second spaces V1 and V2 are defined by the cover member 6 and the lower chamber 7, the pressure adjusters 8A and 8B vacuate or decompress the first and second spaces V1 and V2 so that the pressures in the first and second spaces V1 and V2 are equalized while decompressing the first and second spaces V1 and V2 at an equal decompression rate.

Next, the decompression unit 3 sets the pressure in the first space V1 to be higher than the pressure in the second space V2 by the pressure adjusters 8A and 8B while keeping the decompressed state of the first and second spaces V1 and V2. Then, as shown in Fig. 2A, the mounting sheet MS is urged toward the second space V2 due to the differential pressure between the first and the second spaces V1 and V2 and is bent so that a central part thereof comes closest to the wafer W. In this condition, when the linear movement motor 22 is driven to elevate the table 21, the mounting sheet MS is gradually attached on the wafer W from a central portion to an outer periphery of the wafer W as shown in Fig. 2B. Then, as shown in Fig. 2C, when the mounting sheet MS is pressed and is kept being pressed onto the elastic member 64 of the cover member 6 by the top face W11 of the convex portion W1, a new third space V3 is created in the first space V1 and between an inside of the elastic member 64 and the mounting sheet MS and a new fourth space V4 (gap) is created in the second space V2 and between the mounting sheet MS and the wafer W.

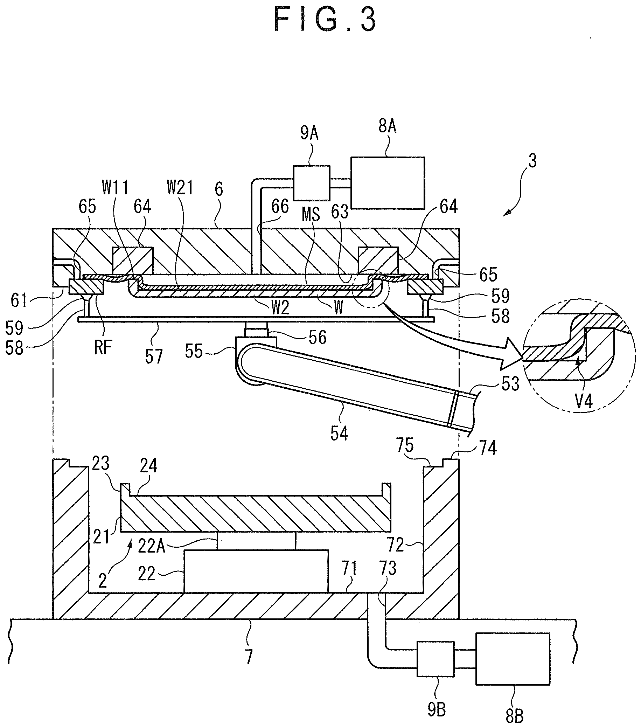

Subsequently, the pressure in the second space V2 is set to be equal to the pressure in the first space V1 by the pressure adjuster 8B. Then, the decompression unit 3 increases the pressures in the third and second spaces V3 and V2 with the pressure adjusters 8A and 8B at the same pressure-increase rate to gradually return the pressures to an atmospheric pressure. Thus, the fourth space V4 is gradually shrunk being urged by the pressure in the third space V3 through the mounting sheet MS and, when the pressure difference between the third space V3 and the fourth space V4 is balanced with the tension of the mounting sheet MS, the fourth space V4 stops shrinking (see Fig. 3). Then, while the ring frame RF is sucked and held via the suction holes 65, the decompression unit 3 lifts the cover member 6 to a predetermined level with the use of a drive unit (not shown). As shown in Fig. 3, the multijoint robot 5 sucks and holds a part of the ring frame RF with the suction pads 59 and places the wafer W on the table 41 with the mounting sheet MS facing a mount face 41A of the table 41.

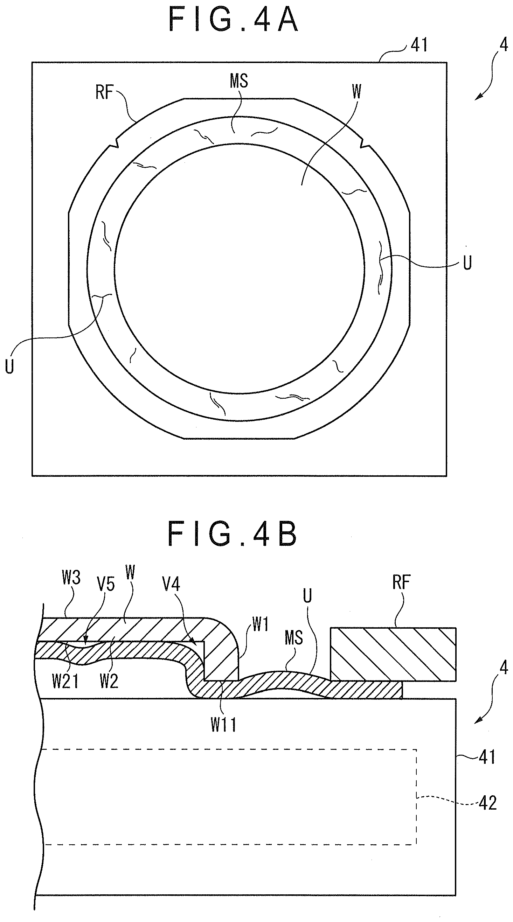

The mounting sheet MS immediately before being heated by the slack removal unit 4 is bent so that the central portion of the mounting sheet MS comes closest to the wafer W before being attached on the wafer W. Accordingly, as shown in Fig. 4A, the mounting sheet MS has irregular waviness U (slack) in a form of ruffles between the wafer W and the ring frame RF. Further, as shown in Fig. 4B, a fifth space V5 (gap) may be present in addition to the fourth space V4.

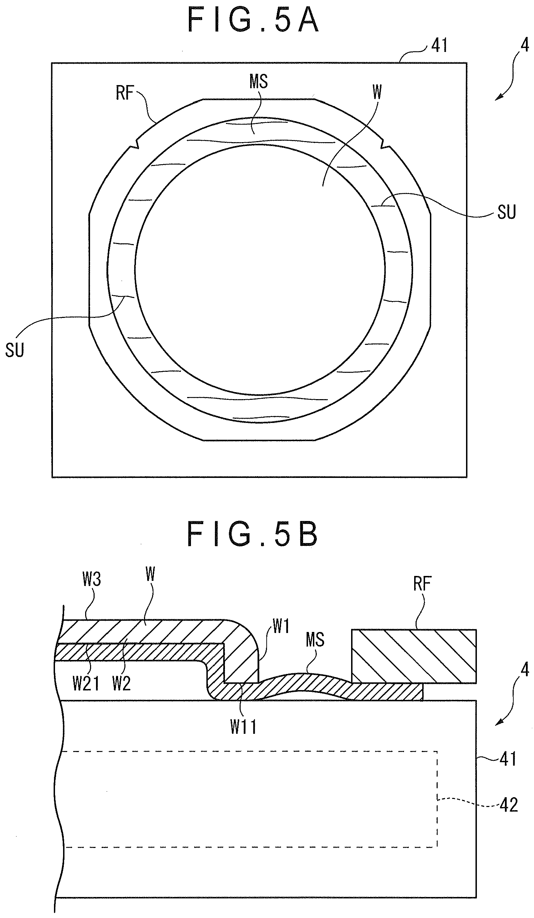

When the mounting sheet MS placed on the table 41 is heated by the slack removal unit 4, a stretch margin is generated on the mounting sheet MS. Then, as shown in Fig. 5B, the mounting sheet MS is closely attached on the wafer W due to pressure difference against the atmospheric pressure to eliminate the fourth and fifth spaces V4 and V5.

Further, when the mounting sheet MS is heated, the mounting sheet MS is stretched in a direction in which tension is applied by the ring frame RF so that the waviness U is transformed into a plurality of lines SU extending in a predetermined direction, as shown in Fig. 5A.

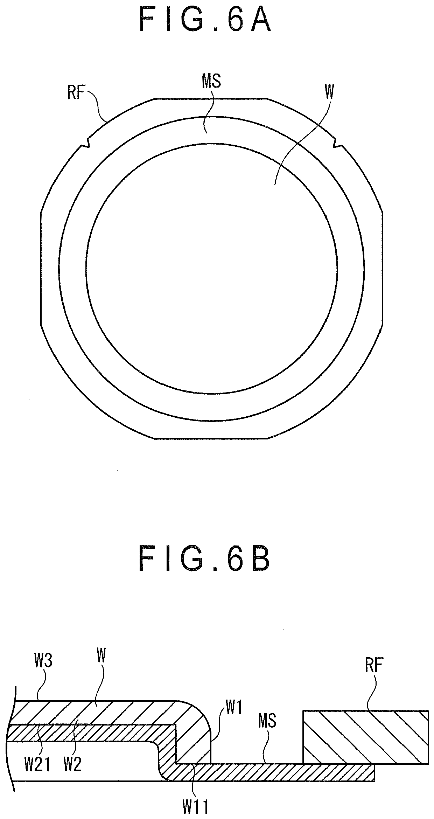

After a predetermined time elapsed, the multijoint robot 5 sucks and holds a part of the ring frame RF with the suction pads 59 and lifts up the mounting sheet MS from the table 41. Then, the mounting sheet MS is naturally cooled to an ambient temperature and the mounting sheet MS is drawn to be contracted by the tension of the ring frame RF to eliminate the lines SU and the slack emerged during the heating as shown in Figs. 6A and 6B. Thus, the displacement of the wafer W relative to the ring frame RF is no more allowed, thereby avoiding damages on the wafer W. It is speculated that the slack is eliminated due to a cause related to a residual stress remained in a base material of the mounting sheet MS that is generated when the base material is stretched for forming the mounting sheet MS.

When the mounting sheet MS is completely attached as discussed above and the wafer W and the ring frame RF are integrated via the mounting sheet MS, the wafer W and the ring frame RF are transferred by the multijoint robot 5 to a next step (e.g. step for peeling the protection sheet).

According to the above-described exemplary embodiment, the following advantages can be obtained.

Even if the waviness U is generated between the wafer W and the ring frame RF when the mounting sheet MS is attached to the wafer W, the sheet adhering device 1 is adapted to heat the mounting sheet MS to transform the waviness U into the plurality of lines SU extending in a predetermined direction. The lines SU naturally cooled to be eliminated, thereby removing the slack.

Further, since the slack removal unit 4 is provided outside the decompression unit 3, the slack-removal step of the mounting sheet MS attached on the wafer W and the attaching step of the next pair of the wafer W and the mounting sheet MS can be performed in an overlapped manner, so that the efficiency of the adhesion process per a unit time can be enhanced.

The best arrangement and process for implementing the invention has been described above. However, it should be understood that the scope of the invention is not limited to the above exemplary embodiment. In other words, while the invention has been particularly explained and illustrated mainly in relation to a specific embodiment, a person skilled in the art could make various modifications in terms of shape, material, quantity or other particulars to the above described embodiment without deviating from the technical idea or any object of the present invention. Further, any descriptions of shape, material or quantity or the like disclosed above are given as examples to enable easy understanding of the invention, and do not limit the present invention, so that descriptions using names of components, with any such limitations of shape, material or quantity or the like removed in part or whole, are included in the present invention.

The invention is defined by the appended claims.

For instance, though an example in which the adherend is the wafer W is discussed in the above exemplary embodiment, the adherend is not restricted to the wafer W. Alternatively, the adherend may be a plate member such as a glass plate, steel plate and resin plate or a member that is not plate-shaped. The examples of the wafer W include silicon semiconductor wafer, a compound semiconductor wafer or the like. The adhesive sheet to be attached to the adherend may be an adhesive sheet for any application to be attached on a plate-shaped member and of any shape such as a sheet, film and tape. Further, though the wafer W attached with a protection sheet on a circuit face thereof is used in the above exemplary embodiment, the protection sheet may not be attached on the wafer W. Further, the irregularities formed on the wafer W may be a bump (an electrode on a semiconductor chip) and the like instead of the convex portion W1.

Though the mounting sheet MS attached with the ring frame RF is supported by the cover member 6 and the lower chamber 7 of the decompression unit 3 in the above exemplary embodiment, the sheet support is not limited to the cover member 6 and the lower chamber 7. For instance, the cover member 6 may be provided in a form of a box as in the lower chamber 7 and a table for supporting the ring frame RF and the mounting sheet MS may be provided on the lower face 61 of the cover member 6. Alternatively, an outer peripheral table may be provided on the bottom face 71 of the lower chamber 7 to surround the adherend support unit 2 and the mounting sheet MS attached with the ring frame RF may be supported on the table.

Further, though the cover member 6, lower chamber 7 and multijoint robot 5 hold a part of the ring frame RF to hold the wafer W and the mounting sheet MS in the above exemplary embodiment, the mounting sheet MS may be held.

In the above exemplary embodiment, the pressure in the first space V1 in which the wafer W is not present is set higher than the pressure in the second space V2 in which the wafer W is present by the pressure adjuster 8A to attach the mounting sheet MS on the wafer W. However, the mounting sheet MS may be pressed to be attached on the wafer W by a different pressing unit. For instance, the pressure in the second space V2 may be set lower than the pressure in the first space VI by the pressure adjuster 8B. Alternatively, an attaching roller may be provided and the attaching roller may be rolled on the mounting sheet MS to attach the mounting sheet MS onto the wafer W. Alternatively, the pressing unit may be configured so that the mounting sheet MS is attached to the wafer W in an atmospheric pressure without keeping the first and second spaces VI and V2 in a decompressed atmosphere when the mounting sheet MS is attached to the wafer W.

Though the wafer W integrated with the ring frame RF is placed on the table 41 so that the mounting sheet MS faces the mount face 41A of the table 41 and the slack removal unit 4 heats the mounting sheet MS, the arrangement is not limited thereto. For instance, in a manner opposite to the exemplary embodiment, the wafer W and the ring frame RF may be placed on the table 41 to face the mount surface 41A, and the mounting sheet MS may be indirectly heated (directly or through air) by heating the wafer W and the ring frame RF with the slack removal unit 4.

Further, though the heater 42 is used as the slack removal unit 4 in the above exemplary embodiment, the arrangement is not limited thereto. In other words, the slack removal unit 4 may be in any form as long as the mounting sheet MS can be directly or indirectly heated. For instance, infrared-ray irradiation equipment or microwave applicator may be used instead of the heater 42. Further, a heating unit such as the heater 42 may be provided outside the table 41 and the mounting sheet MS may be heated by the heater 42 from above or from a lateral side.

The slack removal unit 4 may be a component that is adapted to remove a slack of the mounting sheet MS in a process other than heating. For instance, when the base material of the mounting sheet MS is provided by a rubber that is more stretchable when being cooled, the slack removal unit 4 may be provided by a cooler in a form of such a Peltier element and the like that is adapted to cool the mounting sheet MS.

Further, though the mounting sheet MS attached to the wafer W is naturally cooled to remove the slack of the mounting sheet MS in the above exemplary embodiment, the mounting sheet MS may alternatively be forcibly cooled with the use of a forcible cooler such as a fan and a cold-air blower. Incidentally, the mounting sheet MS has characteristics such that the waviness U is transformed into a plurality of lines SU as shown in Fig. 5A when the mounting sheet MS is cooled and the lines SU are subsequently eliminated to remove the slack when the mounting sheet MS is naturally heated (i.e. temperature-raised).

Though the multijoint robot 5 is used in the above exemplary embodiment, the unit for transferring the wafer W is not limited to the multijoint robot 5. In other words, any transfer unit may be used as long as the wafer W attached with the mounting sheet MS is transferrable to the slack removal unit 4. For instance, the table 41 including the heater 42 may be provided to be slidably driven by a uniaxial robot and, when the cover member 6 is separated from the lower chamber 7, the table 41 may be moved between the cover member 6 and the lower chamber 7 to transfer the ring frame RF attached with the mounting sheet MS to the cover member 6 or the wafer W attached with the mounting sheet MS may be drawn out from the cover member 6.

Further, the drive unit mentioned in the above exemplary embodiment may be provided by: motorized equipment such as a rotary motor, linear movement motor, linear motor, uniaxial robot and multijoint robot; an actuator such as an air cylinder, hydraulic cylinder, rodless cylinder; or a direct or an indirect combination of the motorized equipment and/or actuator, which may be the same as those mentioned in the exemplary embodiment.

### EXPLANATION OF CODES

- 1: sheet adhering device
- 4: slack removal unit
- 8A,8B: pressure adjuster (pressing unit)
- MS: mounting sheet (adhesive sheet)
- RF: ring frame (frame)
- W: wafer (adherend)

## Claims

1. A sheet adhering device (1) arranged to attach an adhesive sheet (MS) to an adherend (W), the adhesive sheet (MS) being attached to an opening of a frame (RF) in advance and sized to protrude beyond an outer periphery of the adherend (W), the sheet adhering device (1) comprising:
a pressing unit arranged to press the adhesive sheet (MS) to the adherend (W) to attach the adhesive sheet (MS) to the adherend (W); and
a slack removal unit (4) that is, or comprises, a heater or cooler arranged to heat or cool the adhesive sheet (MS) to remove a slack of a part of the adhesive sheet (MS) protruded beyond the outer periphery of the adherend (W) after being attached by the pressing unit,
wherein the sheet attaching device (1) is configured to cool the adhesive sheet (MS) naturally or forcibly, after heating by the slack removal unit (4), or
wherein the sheet attaching device (1) is configured to heat the adhesive sheet (MS) naturally, after cooling by the slack removal unit (4).

2. The sheet adhering device (1) according to Claim 1, wherein the sheet attaching device is configured to cool the adhesive sheet (MS) naturally, after heating by the slack removal unit (4).

3. A sheet adhering method for attaching an adhesive sheet (MS) to an adherend (W), the method comprising:
attaching the adhesive sheet (MS) in advance to an opening of a frame (RF), the adhesive sheet (MS) being sized to protrude beyond an outer periphery of the adherend (W);
pressing the adhesive sheet (MS) attached to the opening of the frame (RF) to attach the adhesive sheet (MS) to the adherend (W); and
heating or cooling the adhesive sheet (MS) to remove a slack of the protruding part of the adhesive sheet (MS) after the adhesive sheet (MS) is attached to the adherend (W),
wherein the adhesive sheet (MS) is naturally or forcibly cooled after heating, or
wherein the adhesive sheet (MS) is naturally heated after cooling.

## Patentansprüche

1. Folienklebevorrichtung (1), die angeordnet ist, um eine Klebefolie (MS) an einer Klebefläche (W) zu befestigen, wobei die Klebefolie (MS) im Voraus an einer Öffnung eines Rahmens (RF) befestigt ist und so bemessen ist, dass sie über einen Außenumfang der Klebefläche (W) hinausragt, wobei die Folienklebevorrichtung (1) umfasst:
eine Presseinheit, die angeordnet ist, um die Klebefolie (MS) an die Klebefläche (W) zu drücken, um die Klebefolie (MS) an der Klebefläche (W) zu befestigen; und
eine Durchhangs-Eliminierungseinheit (4), die ein Heiz- oder Kühlgerät ist oder umfasst, das zum Erwärmen oder Abkühlen der Klebefolie (MS) angeordnet ist, um einen Durchhang eines Teils der Klebefolie (MS) zu eliminieren, der über den äußeren Umfang der Klebefläche (W) hinausragt, nachdem er durch die Presseinheit befestigt wurde,
wobei die Folienbefestigungsvorrichtung (1) konfiguriert ist, um die Klebefolie (MS) nach dem Erwärmen durch die Durchhangs-Eliminierungseinheit (4) natürlich oder zwangsweise abzukühlen, oder
wobei die Folienbefestigungsvorrichtung (1) konfiguriert ist, um die Klebefolie (MS) nach dem Abkühlen durch die Durchhangs-Eliminierungseinheit (4) natürlich zu erwärmen.

2. Folienklebevorrichtung (1) nach Anspruch 1, wobei die Folienbefestigungsvorrichtung konfiguriert ist, um die Klebefolie (MS) nach dem Erwärmen durch die Durchhangs-Eliminierungseinheit (4) natürlich abzukühlen.

3. Folienklebeverfahren zum Befestigen einer Klebefolie (MS) an einer Klebefläche (W), wobei das Verfahren umfasst:
Anbringen der Klebefolie (MS) im Voraus an einer Öffnung eines Rahmens (RF), wobei die Klebefolie (MS) so bemessen ist, dass sie über einen Außenumfang der Klebefläche (W) hinausragt;
Pressen der an der Öffnung des Rahmens (RF) befestigten Klebefolie (MS), um die Klebefolie (MS) an der Klebefläche (W) zu befestigen; und
Erwärmen oder Abkühlen der Klebefolie (MS), um einen Durchhang des überstehenden Teils der Klebefolie (MS) zu eliminieren, nachdem die Klebefolie (MS) an der Klebefläche (W) befestigt wurde,
wobei die Klebefolie (MS) nach dem Erwärmen natürlich oder zwangsweise abgekühlt wird, oder
wobei die Klebefolie (MS) nach dem Abkühlen natürlich erwärmt wird.

## Revendications

1. Dispositif d'adhérence de feuille (1) agencé pour attacher une feuille adhésive (MS) à une partie adhérée (W), la feuille adhésive (MS) étant attachée à une ouverture d'un cadre (RF) à l'avance et dimensionnée pour faire saillie au-delà d'une périphérie extérieure de la partie adhérée (W), le dispositif d'adhérence de feuille (1) comprenant :
une unité de pressage agencée pour presser la feuille adhésive (MS) à la partie adhérée (W) afin d'attacher la feuille adhésive (MS) à la partie adhérée (W) ; et
une unité d'élimination de relâchement (4) qui est, ou comprend, un élément de chauffage ou élément de refroidissement pour chauffer ou refroidir la feuille adhésive (MS) pour éliminer un relâchement d'une partie de la feuille adhésive (MS) faisant saillie au-delà de la périphérie extérieure de la partie adhérée (W) après avoir été attachée par l'unité de pressage,
dans lequel le dispositif d'attache de feuille (1) est configuré pour refroidir la feuille adhésive (MS) naturellement ou de force, après chauffage par l'unité d'élimination de relâchement (4), ou
dans lequel le dispositif d'attache de feuille (1) est configuré pour chauffer la feuille adhésive (MS) naturellement, après refroidissement par l'unité d'élimination de relâchement (4).

2. Dispositif d'adhérence de feuille (1) selon la revendication 1, dans lequel le dispositif d'attache de feuille est configuré pour refroidir la feuille adhésive (MS) naturellement, après chauffage par l'unité d'élimination de relâchement (4).

3. Procédé d'adhérence de feuille pour attacher une feuille adhésive (MS) à une partie adhérée (W), le procédé comprenant :
l'attache de la feuille adhésive (MS) à l'avance à une ouverture d'un cadre (RF), la feuille adhésive (MS) étant dimensionnée pour faire saillie au-delà d'une périphérie extérieure de la partie adhérée (W) ;
le pressage de la feuille adhésive (MS) attachée à l'ouverture du cadre (RF) pour attacher la feuille adhésive (MS) à la partie adhérée (W) ; et
le chauffage ou le refroidissement de la feuille adhésive (MS) pour éliminer un relâchement de la partie saillante de la feuille adhésive (MS) après que la feuille adhésive (MS) a été attachée à la partie adhérée (W),
dans lequel la feuille adhésive (MS) est refroidie naturellement ou de force après chauffage, ou
dans lequel la feuille adhésive (MS) est chauffée naturellement après refroidissement.
